# EUROPEAN PATENT APPLICATION

(11) **EP 4 207 315 A1**
(43) Date of publication of application: **05.07.2023**
(21) Application number: 21908442.3
(22) Date of filing: 11.05.2021
(51) Int. Cl.: H01L 31/048

(54) **PATTERNED ADHESIVE FILM AND PHOTOVOLTAIC ASSEMBLY**

(30) Priority: 21.12.2020 CN 202011522327
(71) Applicant: Hangzhou First Applied Material Co., Ltd., Hangzhou, Zhejiang 311300 (CN)
(72) Inventor: DENG, Wei, Hangzhou, Zhejiang 311300 (CN); YANG, Chufeng, Hangzhou, Zhejiang 311300 (CN); WU, Qian, Hangzhou, Zhejiang 311300 (CN)
(74) Representative: Fuchs Patentanwälte Partnerschaft mbB
(86) International application number: PCT/CN2021/093105
(87) International publication number: WO 2022/134431

(57) **Abstract**

Provided are a patterned adhesive film and a photovoltaic assembly. The patterned adhesive film includes a bottom-layer adhesive film and a patterned coating layer arranged on the surface of the bottom-layer adhesive film, the minimum torque value ML of the bottom-layer adhesive film at 100 °C is 0.2-2.5 dN·m, and the elongation at break of the patterned coating layer is ≥20%. Therefore, while laminating is performed on the photovoltaic assembly including the patterned adhesive film, the bottom-layer adhesive film has relatively low fluidity, and the elongation at break of the patterned coating layer may be matched with the bottom-layer adhesive film having the relatively low fluidity, such that the cracking problem of the patterned adhesive film is avoided in the laminating process of the photovoltaic assembly.

## Description

### Technical Field

The present disclosure relates to the technical field of photovoltaic assemblies, in particular to a patterned adhesive film and a photovoltaic assembly.

### Background

With the advent of the era of affordable photovoltaic access to the Internet, it becomes the consensus of the industry to continuously improve the power generation efficiency of photovoltaic assemblies. The technological innovations in the field of cell chips include a double-sided cell, a half-chip cell, a laminated cell and the like, and the innovations in packaging materials include a white adhesive film, a patterned transparent backplate, patterned glass and the like, herein the double-sided cell may be used in combination with the half-chip cell, the laminated cell and other forms to improve the generated power of the cell chips as much as possible, therefore, the double-sided cell becomes the mainstream development direction of the photovoltaic industry. Conventional packaging materials do not perfectly match the double-sided cell, and there is packaging loss at the gap of assemblies, but the patterned adhesive film may solve this problem well.

However, the tensile property of a patterned coating layer is worse than that of the adhesive film. In the laminating process, the patterned coating layer is easy to crack due to the flow of the adhesive film.

### Summary

A main purpose of the present disclosure is to provide a patterned adhesive film and a photovoltaic assembly, as to solve a problem in an existing technology that the patterned adhesive film cracks in the laminating process of the photovoltaic assembly.

In order to achieve the above purpose, according to one aspect of the present disclosure, a patterned adhesive film is provided, the patterned adhesive film includes a bottom-layer adhesive film and a patterned coating layer arranged on the surface of the bottom-layer adhesive film, the minimum torque value ML of the bottom-layer adhesive film at 100°C is 0.2-2.5 dN. m, and the elongation at break of the patterned coating layer is ≥ 20%.

Further, the minimum torque value ML of the above adhesive film at 100°C is 0.4-2.0 dN·m, and further, it is preferably 0.6-1.5 dN·m.

Further, the above bottom-layer adhesive film is a single-layer or multi-layer adhesive film obtained from ethylene-vinyl acetate copolymer and/or octene-polyolefin, when the bottom-layer adhesive film is preferably an adhesive film formed by cross-linking of the ethylene-vinyl acetate copolymer, the pre-crosslinking degree of the bottom-layer adhesive film is 5-60%, when the bottom-layer adhesive film is preferably an adhesive film formed by cross-linking of the octene-polyolefin, the pre-crosslinking degree of the bottom-layer adhesive film is 1-50%, and when the bottom-layer adhesive film is preferably an adhesive film formed by mixed cross-linking of the ethylene-vinyl acetate copolymer and the octene-polyolefin, the pre-crosslinking degree of the bottom-layer adhesive film is 1-50%.

Further, the elongation at break of the above patterned coating layer is ≥30%, and further, the elongation at break of the patterned coating layer is preferably ≥40%.

Further, the adhesive force between the above bottom-layer adhesive film and the patterned coating layer is ≥ 30 N/cm, the adhesive force between the bottom-layer adhesive film and the patterned coating layer is preferably ≥40 N/cm, and further, the adhesive force between the bottom-layer adhesive film and the patterned coating layer is preferably ≥50 N/cm.

Further, the above patterned coating layer is formed by curing a coating composition, and calculated by a mass percentage, the coating composition includes: 20-60% of an ultraviolet (UV) resin, 10-30% of a diluted monomer, 0.5-5% of a photoinitiator, 20-50% of a titanium dioxide and 1-5% of an auxiliary agent, preferably the elongation of the UV resin is ≥100%; preferably, the UV resin is selected from any one or more of polyurethane acrylate, polyester acrylate and pure acrylate; the polyurethane acrylate is preferably selected from any one or more of CN8881NS, CN8887NS, CN8888NS, CN9001NS, CN9021, CN966J75NS, 6148J-75, DR-U299, and DR-U384, the polyester acrylate is preferably selected from any one or more of CN704, CN710, CN3108NS, DR-E524, and the pure acrylate is preferably selected from any one or more of 6584N-1, DR-A845, and DR-A822; preferably the diluted monomer refers to an organic compound containing a C=C double bond, the molecular weight of the diluted monomer is preferably 100-1000, and the diluted monomer is preferably selected from any one or more of (methyl) acrylate and vinyl ether; the photoinitiator is preferably an ultraviolet photoinitiator, and the ultraviolet photoinitiator is preferably selected from any one or more of a photoinitiator TPO, a photoinitiator 184, a photoinitiator 1173 and a photoinitiator TPO-L; and the auxiliary agent is preferably selected from any one or more of a dispersing agent, a defoaming agent and a leveling agent, the dispersing agent is preferably selected from any one or more of an anionic dispersing agent and a polymeric dispersing agent, the defoaming agent is preferably selected from any one or more of an acrylate defoaming agent and an organosilicon defoaming agent, and the leveling agent is preferably selected from any one or more of an acrylate leveling agent and a fluorocarbon leveling agent.

Further, the mass ratio of the UV resin to the diluted monomer is 1:1-5:1.

Further, the peripheral size of the patterned coating layer is consistent with the size of the photovoltaic assembly, the grid hollow area of the patterned coating layer is consistent with the shape of a cell chip laid on the photovoltaic assembly, and the thickness of the patterned coating layer is preferably 10-100 µm, preferably 20-100 µm.

Further, the above bottom-layer adhesive film is a multi-layer co-extruded film, and the thickness of the bottom-layer adhesive film is preferably 300-1000 µm.

In another typical implementation mode of the present disclosure, a photovoltaic assembly is provided, the photovoltaic assembly includes a first glass layer, a transparent adhesive film, a cell chip, a photovoltaic adhesive film, a second glass layer or a photovoltaic backplate that are stacked successively, the photovoltaic adhesive film is the previously described patterned adhesive film, and the grid hollow area of the patterned coating layer of the patterned adhesive film is arranged corresponding to the cell chip one by one.

A technical scheme of the present disclosure is applied, the elongation at break of the patterned coating layer in the patterned adhesive film of the present disclosure is ≥20%, and the minimum torque value ML of the bottom-layer adhesive film at 100°C is ≥0.2 dN.m. Therefore, while laminating is performed on the photovoltaic assembly including the patterned adhesive film, the bottom-layer adhesive film has relatively low fluidity, and the elongation at break of the patterned coating layer may be matched with the bottom-layer adhesive film having the relatively low fluidity, such that the cracking problem of the patterned adhesive film is avoided in the laminating process of the photovoltaic assembly.

### Detailed Description of the Embodiments

It should be noted that embodiments in the present disclosure and features in the embodiments may be combined with each other without conflicting. The present disclosure is described in detail below in combination with the embodiments.

As analyzed in the background, there is a problem in an existing technology that the patterned adhesive film cracks in the laminating process of the photovoltaic assembly. In order to solve this problem, the present disclosure provides a patterned adhesive film and a photovoltaic assembly.

In a typical implementation mode of the present disclosure, a patterned adhesive film is provided, the patterned adhesive film includes a bottom-layer adhesive film and a patterned coating layer arranged on the surface of the bottom-layer adhesive film, the minimum torque value ML of the bottom-layer adhesive film at 100 °C is 0.2-2.5 dN·m, and the elongation at break of the patterned coating layer is ≥20%.

The elongation at break of the patterned coating layer in the patterned adhesive film of the present disclosure is ≥20%, and the minimum torque value ML of the bottom-layer adhesive film at 100 °C is ≥0.2 dN m. Therefore, while laminating is performed on the photovoltaic assembly including the patterned adhesive film, the bottom-layer adhesive film has relatively low fluidity, and the elongation at break of the patterned coating layer may be matched with the bottom-layer adhesive film having the relatively low fluidity, such that the cracking problem of the patterned adhesive film is avoided in the laminating process of the photovoltaic assembly.

In order to further reduce the fluidity of the bottom-layer adhesive film, so that it is easier to match with the patterned coating layer, and thus the probability of cracking of the patterned adhesive film in the laminating process of the photovoltaic assembly is reduced as much as possible, the minimum torque value ML of the above adhesive film at 100 °C is preferably 0.4-2.0 dN·m, and further, it is preferably 0.6-1.5 dN·m.

In order to more easily control the torque value ML of the bottom-layer adhesive film, and thus control its fluidity, the above bottom-layer adhesive film is preferably a single-layer or multi-layer adhesive film obtained from ethylene-vinyl acetate copolymer and/or octene-polyolefin, when the bottom-layer adhesive film is preferably an adhesive film formed by cross-linking of the ethylene-vinyl acetate copolymer, the pre-crosslinking degree of the bottom-layer adhesive film is 5-60%, when the bottom-layer adhesive film is preferably an adhesive film formed by cross-linking of the octene-polyolefin, the pre-crosslinking degree of the bottom-layer adhesive film is 1-50%, and when the bottom-layer adhesive film is preferably an adhesive film formed by mixed cross-linking of the ethylene-vinyl acetate copolymer and the octene-polyolefin, the pre-crosslinking degree of the bottom-layer adhesive film is 1-50%.

In order to make the elongation at break of the patterned coating layer play a synergistic role with the fluidity of the bottom-layer adhesive film, the elongation at break of the above patterned coating layer is preferably ≥30%, and further, the elongation at break of the patterned coating layer is preferably ≥40%.

In order to improve the bonding strength between the bottom-layer adhesive film and the patterned coating layer, as to avoid the dislocation problem of the bottom-layer adhesive film and the patterned coating layer in the laminating process as much as possible, the adhesive force between the above bottom-layer adhesive film and the patterned coating layer is preferably ≥ 30 N/cm, the adhesive force between the bottom-layer adhesive film and the patterned coating layer is preferably ≥40 N/cm, and further, the adhesive force between the bottom-layer adhesive film and the patterned coating layer is preferably ≥50 N/cm.

In an embodiment of the present disclosure, the above patterned coating layer is formed by curing a coating composition, and calculated by a mass percentage, the coating composition includes: 20-60% of a UV resin, 10-30% of a diluted monomer, 0.5-5% of a photoinitiator, 20-50% of a titanium dioxide and 1-5% of an auxiliary agent; preferably, the UV resin is selected from any one or more of polyurethane acrylate, polyester acrylate and pure acrylate; the polyurethane acrylate is preferably selected from any one or more of CN8881NS, CN8887NS, CN8888NS, CN9001NS, CN9021, CN966J75NS, 6148J-75, DR-U299, and DR-U384, the polyester acrylate is preferably selected from any one or more of CN704, CN710, CN3108NS, DR-E524, and the pure acrylate is preferably selected from any one or more of 6584N-1, DR-A845, and DR-A822; preferably the diluted monomer refers to an organic compound containing a C=C double bond, the molecular weight of the diluted monomer is preferably 100-1000, and the diluted monomer is preferably selected from any one or more of (methyl) acrylate and vinyl ether; the photoinitiator is preferably an ultraviolet photoinitiator, and the ultraviolet photoinitiator is preferably selected from any one or more of a photoinitiator TPO, a photoinitiator 184, a photoinitiator 1173 and a photoinitiator TPO-L; and the auxiliary agent is preferably selected from any one or more of a dispersing agent, a defoaming agent and a leveling agent, the dispersing agent is preferably selected from any one or more of an anionic dispersing agent and a polymeric dispersing agent, the defoaming agent is preferably selected from any one or more of an acrylate defoaming agent and an organosilicon defoaming agent, and the leveling agent is preferably selected from any one or more of an acrylate leveling agent and a fluorocarbon leveling agent.

The above UV resin with the high ductility, matched with the above diluted monomer with the excellent flexibility and the preferred photoinitiator, titanium dioxide and auxiliary agent, is more helpful to the synergy between components on the basis of the comprehensive category and amount of each component, thereby the patterned coating layer with the good elongation at break is obtained.

In order to improve the polymerization effect between the UV resin and the diluted monomer, as to obtain the patterned coating layer with the better performance, the mass ratio of the above UV resin and the diluted monomer is preferably 1:1-5:1.

In order to better match with the bottom-layer adhesive film, the peripheral size of the above patterned coating layer is consistent with the size of the photovoltaic assembly, the grid hollow area of the patterned coating layer is consistent with the shape of a cell chip laid on the photovoltaic assembly, and the thickness of the patterned coating layer is preferably 10-100 µm, preferably 20-100 µm.

In order to better match with the gap between the cell chips in the photovoltaic assembly, the above bottom-layer adhesive film is a multi-layer co-extruded film, and the thickness of the bottom-layer adhesive film is preferably 300-1000 µm.

In another typical implementation mode of the present disclosure, a photovoltaic assembly is provided, the photovoltaic assembly includes a first glass layer, a transparent adhesive film, a cell chip, a photovoltaic adhesive film, a second glass layer or a photovoltaic backplate that are stacked successively, the photovoltaic adhesive film is the previously described patterned adhesive film, and the grid hollow area of the patterned coating layer of the patterned adhesive film is arranged corresponding to the cell chip one by one.

The beneficial effects of the present disclosure are described below in combination with specific embodiments and contrast examples.

### Embodiment 1

The coating composition included: 60 parts of CN8881NS, 5 parts of isobornyl acrylate, 5 parts of neopentyl glycol diacrylate, 0.5 parts of photoinitiator 184, 27.5 parts of titanium dioxide, 1 part of BYK-110 and 1 part of BYK-1790.

The ethylene-vinyl acetate copolymer was extruded and cast, to obtain a multi-layer bottom-layer adhesive film with 300 µm of the thickness, and the bottom-layer adhesive film was irradiated by an electron beam, to obtain the bottom-layer adhesive film with 45% of the pre-crosslinking degree, and the ML value of the bottom-layer adhesive film at 100 °C was measured to be 1.5 dN·m by using a vulcanizer (Taiwan U-CAN 2010SD), and then the above coating composition was mixed evenly and printed on the bottom-layer adhesive film, to obtain a patterned coating layer with 20 µm of the thickness, the elongation at break of the patterned coating layer was 50%, and a patterned adhesive film was finally obtained.

### Embodiment 2

The difference between Embodiment 2 and Embodiment 1 was that the coating composition included: 40 parts of CN966J75NS, 20 parts of isobornyl acrylate, 10 parts of neopentyl glycol diacrylate, 2 parts of 184, 27 parts of titanium dioxide, 0.5 parts of BYK-111 and 0.5 parts of BYK-065, a patterned adhesive film was finally obtained, and the elongation at break of a patterned coating layer was 40%.

### Embodiment 3

The difference between Embodiment 3 and Embodiment 1 was that the coating composition included: 30 parts of CN704, 10 parts of isobornyl acrylate, 10 parts of neopentyl glycol diacrylate, 5 parts of 184, 40 parts of titanium dioxide, 3 parts of BYK-110 and 2 parts of BYK-354, a patterned adhesive film was finally obtained, and the elongation at break of a patterned coating layer was 30%.

### Embodiment 4

The difference between Embodiment 4 and Embodiment 1 was that the coating composition included: 20 parts of 6584N-1, 15 parts of isobornyl acrylate, 10 parts of neopentyl glycol diacrylate, 1 part of 184, 50 parts of titanium dioxide, 3 parts of BYK-111 and 1 part of BYK-052, a patterned adhesive film was finally obtained, and the elongation at break of a patterned coating layer was 20%.

### Embodiment 5

The difference between Embodiment 5 and Embodiment 1 was that the ethylene-vinyl acetate copolymer was extruded and cast, to obtain a multi-layer bottom-layer adhesive film with 300 µm of the thickness, and the bottom-layer adhesive film was irradiated by an electron beam, to obtain the bottom-layer adhesive film with 15% of the pre-crosslinking degree, and the ML value of the bottom-layer adhesive film at 100 °C was measured to be 0.6 dN.m by a vulcanizer (Taiwan U-CAN 2010SD), and a patterned adhesive film was finally obtained.

### Embodiment 6

The difference between Embodiment 6 and Embodiment 1 was that the ethylene-vinyl acetate copolymer was extruded and cast, to obtain a multi-layer bottom-layer adhesive film with 300 µm of the thickness, and the bottom-layer adhesive film was irradiated by an electron beam, to obtain the bottom-layer adhesive film with 30% of the pre-crosslinking degree, and the ML value of the bottom-layer adhesive film at 100 °C was measured to be 1.0 dN m by a vulcanizer (Taiwan U-CAN 2010SD), and a patterned adhesive film was finally obtained.

### Embodiment 7

The difference between Embodiment 7 and Embodiment 1 was that the ethylene-vinyl acetate copolymer was extruded and cast, to obtain a multi-layer bottom-layer adhesive film with 300 µm of the thickness, and the bottom-layer adhesive film was irradiated by an electron beam, to obtain the bottom-layer adhesive film with 10% of the pre-crosslinking degree, and the ML value of the bottom-layer adhesive film at 100 °C was measured to be 0.4 dN m by a vulcanizer (Taiwan U-CAN 2010SD), and a patterned adhesive film was finally obtained.

### Embodiment 8

The difference between Embodiment 8 and Embodiment 1 was that the ethylene-vinyl acetate copolymer was extruded and cast, to obtain a multi-layer bottom-layer adhesive film with 300 µm of the thickness, and the bottom-layer adhesive film was irradiated by an electron beam, to obtain the bottom-layer adhesive film with 55% of the pre-crosslinking degree, and the ML value of the bottom-layer adhesive film at 100 °C was measured to be 2.0 dN·m by a vulcanizer (Taiwan U-CAN 2010SD), and a patterned adhesive film was finally obtained.

### Embodiment 9

The difference between Embodiment 9 and Embodiment 1 was that the ethylene-vinyl acetate copolymer was extruded and cast, to obtain a multi-layer bottom-layer adhesive film with 300 µm of the thickness, and the bottom-layer adhesive film was irradiated by an electron beam, to obtain the bottom-layer adhesive film with 5% of the pre-crosslinking degree, and the ML value of the bottom-layer adhesive film at 100 °C was measured to be 0.2 dN m by a vulcanizer (Taiwan U-CAN 2010SD), and a patterned adhesive film was finally obtained.

### Embodiment 10

The difference between Embodiment 10 and Embodiment 1 was that the ethylene-vinyl acetate copolymer was extruded and cast, to obtain a multi-layer bottom-layer adhesive film with 300 µm of the thickness, and the bottom-layer adhesive film was irradiated by an electron beam, to obtain the bottom-layer adhesive film with 60% of the pre-crosslinking degree, and the ML value of the bottom-layer adhesive film at 100 °C was measured to be 2.5 dN m by a vulcanizer (Taiwan U-CAN 2010SD), and a patterned adhesive film was finally obtained.

### Embodiment 11

The difference between Embodiment 11 and Embodiment 1 was that the mass ratio of the UV resin to the diluted monomer was 1:1, the elongation at break of a patterned coating layer was 25%, and a patterned adhesive film was finally obtained.

### Embodiment 12

The difference between Embodiment 12 and Embodiment 1 was that the mass ratio of the UV resin to the diluted monomer was 3:1, the elongation at break of a patterned coating layer was 40%, and a patterned adhesive film was finally obtained.

### Embodiment 13

The difference between Embodiment 13 and Embodiment 1 was that the mass ratio of the UV resin to the diluted monomer was 5:1, the elongation at break of a patterned coating layer was 45%, and a patterned adhesive film was finally obtained.

### Embodiment 14

The difference between Embodiment 14 and Embodiment 1 was that the pre-crosslinking degree of a bottom-layer adhesive film was 25%, the ML value of the bottom-layer adhesive film at 100 °C was measured to be 0.8 dN m by using a vulcanizer (Taiwan U-CAN 2010SD), and a patterned adhesive film was finally obtained.

### Embodiment 15

The difference between Embodiment 15 and Embodiment 1 was that the pre-crosslinking degree of a bottom-layer adhesive film was 40%, the ML value of the bottom-layer adhesive film at 100 °C was measured to be 1.3 dN·m by using a vulcanizer (Taiwan U-CAN 2010SD), and a patterned adhesive film was finally obtained.

### Embodiment 16

The difference between Embodiment 16 and Embodiment 1 was that the thickness of a bottom-layer adhesive film was 1000 µm, the thickness of a patterned coating layer was 100 µm, the elongation at break of the patterned coating layer was 75%, and a patterned adhesive film was finally obtained.

### Embodiment 17

The difference between Embodiment 17 and Embodiment 1 was that the thickness of a bottom-layer adhesive film was 500 µm, the thickness of a patterned coating layer was 10 µm, the elongation at break of the patterned coating layer was 35%, and a patterned adhesive film was finally obtained.

### Contrast example 1

The difference between Contrast example 1 and Embodiment 1 was that the coating composition included: 60 parts of CNUVE151NS, 5 parts of isobornyl acrylate, 5 parts of neopentyl glycol diacrylate, 1 part of 184, 27 parts of titanium dioxide, 1 part of BYK-110 and 1 part of BYK-1790. The elongation at break of a patterned coating layer was 15%, and a patterned adhesive film was finally obtained.

### Contrast example 2

The difference between Contrast example 2 and Embodiment 1 was that the ethylene-vinyl acetate copolymer was extruded and cast, to obtain a multi-layer bottom-layer adhesive film with 300 µm of the thickness, and the bottom-layer adhesive film was irradiated by an electron beam, to obtain the bottom-layer adhesive film with 2% of the pre-crosslinking degree, and the ML value of the bottom-layer adhesive film at 100 °C was measured to be 0.1 dN·m by using a vulcanizer (Taiwan U-CAN 2010SD), and a patterned adhesive film was finally obtained.

The elongation at break of the patterned coating layers in the patterned adhesive films prepared by Embodiments 1 to 17, Contrast example 1 and Contrast example 2 was respectively tested by the GB/T13541-92 test standard.

The adhesive force between the bottom-layer adhesive film and the patterned coating layer of any one patterned adhesive film prepared by Embodiments 1 to 17, Contrast example 1 and Contrast example was respectively tested by the GB/T2790 test standard (marked as A), and test results were listed in Table 1.

### Performance test:

Photovoltaic assemblies were made according to the sequence of glass, a transparent adhesive film, a cell chip, any one patterned adhesive film prepared in Embodiments 1 to 17, Contrast example 1 and Contrast example 2, and glass, and then laminated at 150°C for 18 min, the patterned cracking conditions after lamination were observed (marked as B), and test results were listed in Table 1.

**Table 1**

| Embodiment/Contrast example | ML value/dN·m | Elongation at break | A/N/cm | B |
|---|---|---|---|---|
| Embodiment 1 | 1.5 | 50% | 70 | Uncracked |
| Embodiment 2 | 1.5 | 40% | 60 | Uncracked |
| Embodiment 3 | 1.5 | 30% | 55 | Uncracked |
| Embodiment 4 | 1.5 | 20% | 45 | Uncracked |
| Embodiment 5 | 0.6 | 50% | 90 | Uncracked |
| Embodiment 6 | 1.0 | 50% | 90 | Uncracked |
| Embodiment 7 | 0.4 | 50% | 85 | Uncracked |
| Embodiment 8 | 2.0 | 50% | 70 | Uncracked |
| Embodiment 9 | 0.2 | 50% | 60 | Uncracked |
| Embodiment 10 | 2.5 | 50% | 50 | Uncracked |
| Embodiment 11 | 1.5 | 25% | 55 | Uncracked |
| Embodiment 12 | 1.5 | 40% | 60 | Uncracked |
| Embodiment 13 | 1.5 | 45% | 65 | Uncracked |
| Embodiment 14 | 0.8 | 50% | 75 | Uncracked |
| Embodiment 15 | 1.3 | 50% | 65 | Uncracked |
| Embodiment 16 | 1.5 | 75% | 100 | Uncracked |
| Embodiment 17 | 1.5 | 35% | 30 | Uncracked |
| Contrast example 1 | 1.5 | 15% | 40 | Cracked |
| Contrast example 2 | 0.1 | 50% | 90 | Cracked |

From the above descriptions, it may be seen that the above embodiments of the present disclosure achieve the following technical effects.

The elongation at break of the patterned coating layer in the patterned adhesive film of the present disclosure is ≥20%, and the minimum torque value ML of the bottom-layer adhesive film at 100 °C is ≥0.2 dN·m. Therefore, while laminating is performed on the photovoltaic assembly including the patterned adhesive film, the bottom-layer adhesive film has relatively low fluidity, and the elongation at break of the patterned coating layer may be matched with the bottom-layer adhesive film having the relatively low fluidity, such that the cracking problem of the patterned adhesive film is avoided in the laminating process of the photovoltaic assembly.

The above are only preferred embodiments of the present disclosure, and are not intended to limit the present disclosure. For those skilled in the art, the present disclosure may have various modifications and changes. Any modifications, equivalent replacements, improvements and the like made within the spirit and principle of the present disclosure shall be included in a scope of protection of the present disclosure.

## Claims

1. A patterned adhesive film, the patterned adhesive film comprises a bottom-layer adhesive film and a patterned coating layer arranged on the surface of the bottom-layer adhesive film, wherein the minimum torque value ML of the bottom-layer adhesive film at 100°C is 0.2-2.5 dN·m, and the elongation at break of the patterned coating layer is ≥20%.

2. The patterned adhesive film according to claim 1, wherein the minimum torque value ML of the adhesive film at 100°C is 0.4-2.0 dN·m, and further, it is preferably 0.6-1.5 dN·m.

3. The patterned adhesive film according to claim 1 or 2, wherein the bottom-layer adhesive film is a single-layer or multi-layer adhesive film obtained from ethylene-vinyl acetate copolymer and/or octene-polyolefin, when the bottom-layer adhesive film is preferably an adhesive film formed by cross-linking of the ethylene-vinyl acetate copolymer, the pre-crosslinking degree of the bottom-layer adhesive film is 5-60%, when the bottom-layer adhesive film is preferably an adhesive film formed by cross-linking of the octene-polyolefin, the pre-crosslinking degree of the bottom-layer adhesive film is 1-50%, and when the bottom-layer adhesive film is preferably an adhesive film formed by mixed cross-linking of the ethylene-vinyl acetate copolymer and the octene-polyolefin, the pre-crosslinking degree of the bottom-layer adhesive film is 1-50%.

4. The patterned adhesive film according to any one of claims 1 to 3, wherein the elongation at break of the patterned coating layer is ≥30%, and further, the elongation at break of the patterned coating layer is preferably ≥40%.

5. The patterned adhesive film according to any one of claims 1 to 3, wherein the adhesive force between the bottom-layer adhesive film and the patterned coating layer is ≥30 N/cm, the adhesive force between the bottom-layer adhesive film and the patterned coating layer is preferably ≥40 N/cm, and further, the adhesive force between the bottom-layer adhesive film and the patterned coating layer is preferably ≥50 N/cm.

6. The patterned adhesive film according to any one of claims 1 to 3, wherein the patterned coating layer is formed by curing a coating composition, and calculated by a mass percentage, the coating composition comprises:
20-60% of an ultraviolet (UV) resin;
10-30% of a diluted monomer;
0.5-5% of a photoinitiator;
20-50% of a titanium dioxide; and
1-5% of an auxiliary agent,
preferably the elongation of the UV resin is ≥100%; preferably, the UV resin is selected from any one or more of polyurethane acrylate, polyester acrylate and pure acrylate; the polyurethane acrylate is preferably selected from any one or more of CN8881NS, CN8887NS, CN8888NS, CN9001NS, CN9021, CN966J75NS, 6148J-75, DR-U299, and DR-U384, the polyester acrylate is preferably selected from any one or more of CN704, CN710, CN3108NS, DR-E524, and the pure acrylate is preferably selected from any one or more of 6584N-1, DR-A845, and DR-A822;
preferably the diluted monomer refers to an organic compound containing a C=C double bond, the molecular weight of the diluted monomer is preferably 100-1000, and the diluted monomer is preferably selected from any one or more of (methyl) acrylate and vinyl ether;
preferably the photoinitiator is an ultraviolet photoinitiator, and the ultraviolet photoinitiator is preferably selected from any one or more of a photoinitiator TPO, a photoinitiator 184, a photoinitiator 1173 and a photoinitiator TPO-L; and
preferably the auxiliary agent is selected from any one or more of a dispersing agent, a defoaming agent and a leveling agent, the dispersing agent is preferably selected from any one or more of an anionic dispersing agent and a polymeric dispersing agent, the defoaming agent is preferably selected from any one or more of an acrylate defoaming agent and an organosilicon defoaming agent, and the leveling agent is preferably selected from any one or more of an acrylate leveling agent and a fluorocarbon leveling agent.

7. The patterned adhesive film according to claim 6, wherein the mass ratio of the UV resin to the diluted monomer is 1:1-5:1.

8. The patterned adhesive film according to claim 6, wherein the peripheral size of the patterned coating layer is consistent with the size of the photovoltaic assembly, the grid hollow area of the patterned coating layer is consistent with the shape of a cell chip laid on the photovoltaic assembly, and the thickness of the patterned coating layer is preferably 10-100 µm, preferably 20-100 µm.

9. The patterned adhesive film according to any one of claims 1 to 3, wherein the bottom-layer adhesive film is a multi-layer co-extruded film, and the thickness of the bottom-layer adhesive film is preferably 300-1000 µm.

10. A photovoltaic assembly, the photovoltaic assembly comprises a first glass layer, a transparent adhesive film, a cell chip, a photovoltaic adhesive film, a second glass layer or a photovoltaic backplate that are stacked successively, wherein the photovoltaic adhesive film is the patterned adhesive film according to any one of claims 1 to 9, and the grid hollow area of the patterned coating layer of the patterned adhesive film is arranged corresponding to the cell chip one by one.
